# EUROPÄISCHE PATENTSCHRIFT

(11) **EP 1 996 004 B1**
(45) Veröffentlichungstag und Bekanntmachung des Hinweises auf die Patenterteilung: **09.07.2014**
(21) Anmeldenummer: 07010429.4
(22) Anmeldetag: 25.05.2007
(51) Int. Cl.: H01L 31/042, H05K 7/20

(54) **Wechselrichtergehäuse**
Inverter casing
Boîtier d'onduleur

(43) Veröffentlichungstag der Anmeldung: 26.11.2008
(73) Patentinhaber: SMA Solar Technology AG, 34266 Niestetal (DE)
(72) Erfinder: Bremicker, Sven, 36211 Alheim-Baumbach (DE); Donth, Andreas, 34295 Edermünde (DE); Domagala, Stefan, 30-199 Rzaska (PL)

(56) Entgegenhaltungen:
- EP-A- 1 848 260
- DE-A1- 10 151 928
- DE-A1-102004 030 457
- DE-U1- 9 320 825
- JP-A- 10 227 489
- US-A1- 2004 226 761

## Beschreibung

Die Erfindung betrifft ein Wechselrichtergehäuse nach dem Oberbegriff des Anspruchs 1.

Wechselrichter dienen bei der Nutzung alternativer Energiequellen, wie z. B. bei PV-Modulen, dazu, Gleichstrom in Wechselstrom umzuwandeln. Ein solcher Wechselrichter weist ein Gehäuse auf, wobei in dem Gehäuse leistungselektronische Bauteile angeordnet sind. Diese leistungselektronischen Bauteile umfassen unter anderem solche Bauelemente, die bei ihrem Betrieb eine nicht unerhebliche Wärme abstrahlen. Dies sind insbesondere Wickelgüter, wie z. B. Drosseln.

In diesem Zusammenhang ist aus der US 2004/226761 A1 eine Antriebseinheit, umfassend einen Motor, einen Generator und ein Getriebe bekannt, die in einem Gehäuse untergebracht sind, wobei auf diesem Gehäuse ein weiteres Gehäuse vorgesehen ist, in dem Wechselrichter untergebracht sind. Das Problem der Wärmeabstrahlung der Wickelgüter in dem Wechselrichter auf andere leistungselektrische Bauteile des Wechselrichters ist hier nicht angesprochen.

Des Weiteren ist bekannt, dass die leistungselektronischen Bauteile gegenüber Umwelteinflüssen, und hier insbesondere gegenüber Feuchtigkeit, geschützt werden müssen, Gehäuse, die solche leistungselektronischen Bauteile aufnehmen, weisen daher zumindest die Schutzartklasse IP65 auf.

Andererseits ist ebenfalls bekannt, dass durch die nicht unerhebliche Wärmeabstrahlung von beispielsweise solchen Wickelgütern beim Einbau derartiger Bauteile in das Gehäuse eines Wechselrichters die Zuverlässigkeit und die Lebensdauer des Gerätes erheblich leidet. Dieser Problematik wird bei einem Gehäuse, das sowohl die leistungselektronischen Bauteile als auch insbesondere Wickelgüter aufnimmt, versucht dadurch entgegenzutreten, dass solche Wickelgüter von beispielsweise Leiterplatten durch Abstrahlbleche getrennt werden, wobei Abstrahlbleche die Aufgabe haben, die Wärmeabstrahlung dieses Wickelgutes unmittelbar an die Leiterplatte nach Möglichkeit zu unterbinden. Hierbei wird zwar erreicht, dass die Leiterplatte nicht unmittelbar der Wärmestrahlung, beispielsweise des Wickelgutes, also z. B. einer Drossel, ausgesetzt ist. Allerdings ist nicht zu verkennen, dass sich bei dieser Ausgestaltung eines Wechselrichtergehäuses die Temperatur im Inneren des Gehäuses innerhalb relativ kurzer Zeit nach Beginn des Betriebes auf einen gleichmäßig hohen Wert einstellt, der der Lebensdauer eines solchen Wechselrichters wenig zuträglich ist.

In diesem Zusammenhang ist aus der DE 10 2004 030 457 A1 bekannt, Wickelgüter außerhalb des eigentlichen Gehäuses für die leistungselektronischen Bauteile unterzubringen. Da die Wickelgüter zum Schutz vor Feuchtigkeit eine weitaus geringere Schutzartklasse benötigen als die typischen leistungselektronischen Bauteile, wie z. B, Leiterplatten und Ähnliches, ist vorgesehen, den Gehäuseteil, der Wickelgüter z. B. in Form von Drosseln aufnimmt, mit Schlitzen zur Belüftung zu versehen und gegebenenfalls auch eine Zwangsbelüftung von außen durch entsprechende Ventilatoren vorzunehmen. Der Vorteil dieser Ausgestaltung besteht in der thermischen Entkopplung der Wickelgüter von den übrigen leistungselektronischen Bauteilen im Gerät, wodurch die Temperatur im Inneren des Gehäuses, also insbesondere in dem Teil des Gehäuses, der die temperaturempfindlichen, leistungselektronischen Bauteile aufnimmt, erheblich reduziert werden kann, wodurch sich die Lebensdauer des Gerätes und schlussendlich auch die Zuverlässigkeit erheblich steigern lässt.

Wie bereits an anderer Stelle erläutert, sind die leistungselektronischen Bauteile vor Feuchtigkeit nach der Schutzartklasse IP65 zu schützen.

Werden nun die beispielsweise Drosseln in einem gesonderten Gehäuseteil untergebracht, so ist die Verbindung durch die Wandung zu den leistungselektronischen Bauteilen in der Form auszubilden, dass diese zumindest der Schutzartklasse des Gehäuses oder Gehäuseteils, das die leisturtgselektronischen Bauteile aufnimmt, entspricht. Nachteilig ist weiterhin, dass bei dieser Ausgestaltung die Wickelgüter, obwohl sie relativ unempfindlich gegenüber Feuchtigkeit sind, eine verhältnismäßig hohe Schutzartklasse aufweisen müssen. Üblicherweise ist dennoch eine gesonderte Abdeckung auch dieses Gehäuseteils zur Aufnahme der Wickelgüter vorgesehen, allein deshalb, um diese Wickelgüter vor UV-Strahlung zu schützen.

Insofern ist festzuhalten, dass mit dieser Konstruktion zwar eine thermische Entkopplung zwischen den Wickelgütern einerseits und den leistungselektronischen Bauteilen andererseits im Gehäuse eines Wechselrichters möglich ist, aber dennoch der konstruktive Aufwand relativ hoch ist, sodass in solcher Weise konstruierte Wechselrichter teuer sind.

Der Erfindung liegt daher die Aufgabe zugrunde, eine thermische Entkopplung zwischen den Wickelgütern eines Wechselrichters und den anderen leistungselektronischen Bauteilen, die nach Möglichkeit vor Wärme zu schützen sind, bereitzustellen, um hierdurch die Lebensdauer und Zuverlässigkeit eines solchen Wechselrichters zu erhöhen, wobei dennoch ein solcher Wechselrichter bzw. das Gehäuse eines solchen Wechselrichters preiswert herstellbar ist, das Wickelgut keiner eigenen Schutzartklasse unterliegen muss und darüber hinaus in Bezug auf die Verkabelung zwischen dem Wickelgut und den leistungselektronischen Bauteilen keine eigene Schutzartklasse vorgesehen sein muss.

Die Aufgabe wird erfindungsgemäß dadurch gelöst, dass die eine erste Gehäusekammer die leistungselektronischen Bauteile des Wechselrichters aufnimmt, dass im

Boden der ersten Gehäusekammer mindestens eine napf- oder topfartige Vertiefung zur Aufnahme der Wärme abgebenden, elektrischen Wickelgüter vorgesehen ist, und dass sich die leistungselektronischen Bauteile oberhalb der zumindest einen Vertiefung in der ersten Gehäusekammer befinden. Eine solche napf- oder topfartige Vertiefung zur Aufnahme der Wickelgüter, z. B. von Drosseln, bietet eine erhebliche Oberfläche, über die von den Wickelgütern erzeugte Wärme nach außen über den Gehäuseboden des Gehäuses des Wechselrichters abgestrahlt werden kann. D. h. die Strahlungswärme wird, insbesondere wenn ein guter Wärmeübergang zwischen dem Gehäuse und dem Wickelgut gegeben ist, nur in geringem Maße in das Gehäuse oder Gehäuseteil abgestrahlt werden, in dem sich die leistungselektronischen Bauteile befinden.

Hieraus wird deutlich, dass die Vorteile der Unterbringung der Wickelgüter in der zu der Gehäusekammer höherer Schutzart gehörenden Vertiefungen kombiniert werden können mit den Vorteilen, die sich daraus ergeben, dass aufgrund der Unterbringung sowohl der leistungselektronischen Bauteile als auch der Wickelgüter in einem Gehäuse keine gesonderten Maßnahmen für die Isolierung, z. B. der elektrischen Verbindung, getroffen werden müssen.

Vorteilhafte Merkmale zu der Erfindung sind den Unteransprüchen zu entnehmen.

So ist insbesondere vorgesehen, dass die Vertiefung durch ein Schottblech und hier insbesondere durch eine wärmedämmendes Schottblech, abdeckbar ist. Durch insbesondere ein solches wärmedämmendes Schottblech, beispielsweise in Form einer Sandwich-Platte, wird die Wärmeabstrahlung des Wickelgutes unmittelbar in das Gehäuse bzw. in die Gehäusekammer, die die leistungselektronischen Bauteile aufnimmt, weiter reduziert.

Um die durch die Wickelgüter auf den Gehäuseboden übertragende Wärme beim Betrieb des Wechselrichters abzuleiten, ist insbesondere vorgesehen, dass auf der Außenseite der Vertiefung Kühlrippen vorgesehen sind. Vorteilhaft sind in diesem Zusammenhang die Kühlrippen nicht nur auf der Außenseite der Vertiefung des Gehäuses vorgesehen, sondern auch seitlich zu der mindestens einen Vertiefung am Gehäuseboden angebracht. Hieraus wird deutlich, dass bevorzugt der gesamte Gehäuseboden einschließlich der Vertiefungen mit entsprechenden Kühlrippen versehen ist.

Anhand der Zeichnungen wird die Erfindung nachstehend beispielhaft näher erläutert.

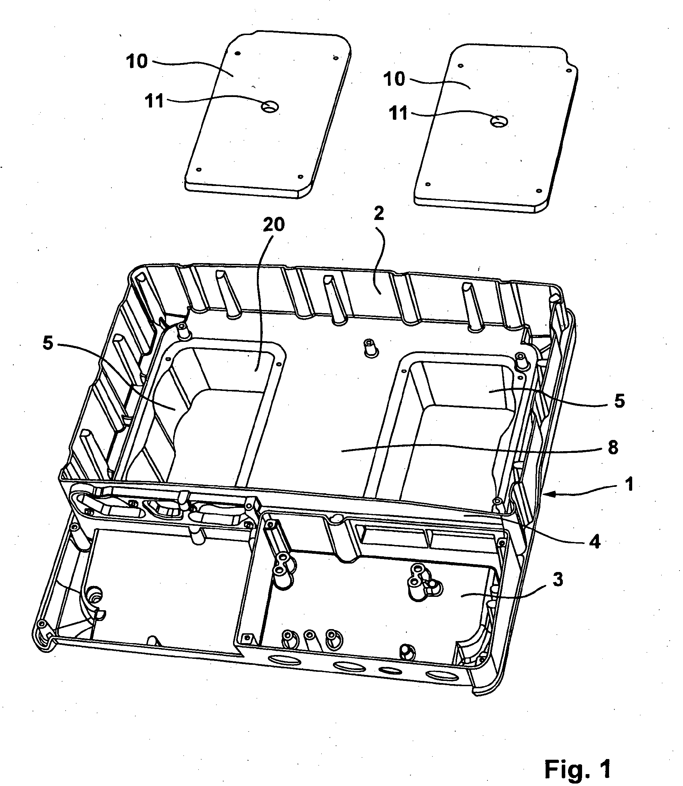

- Fig. 1: zeigt das Gehäuse ohne Gehäusedeckel perspektivisch in einer Ansicht von oben, wobei die Wickelgüter in den Vertiefungen des Gehäusebodens weggelassen sind;
- Fig. 2: zeigt eine Ansicht von unten auf das Gehäuse.

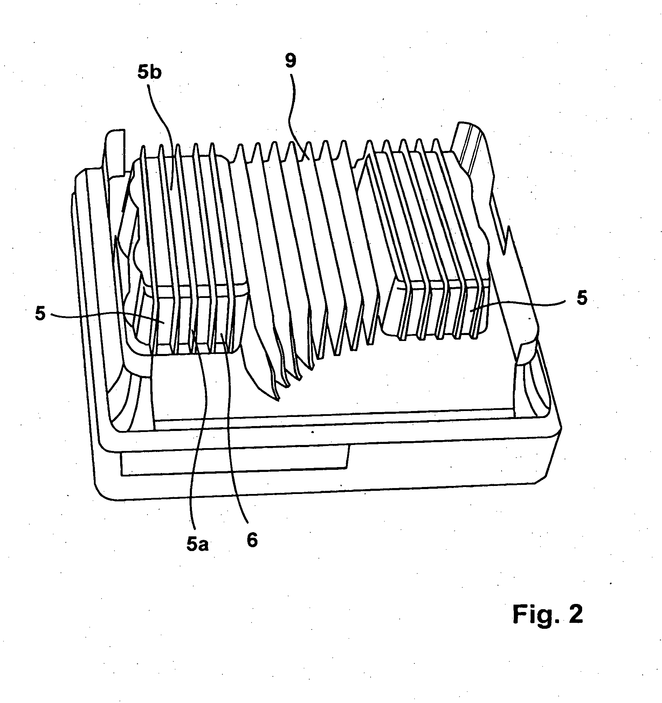

Das insgesamt mit 1 bezeichnete Gehäuse besitzt die beiden Gehäusekammern 2, 3, die durch eine Wandung 4 voneinander getrennt sind. Gegenstand der Erfindung ist die Ausbildung der Gehäusekammer 2. Die Gehäusekammer 2 weist die beiden mit 5 bezeichneten Vertiefungen auf, die der Aufnahme von Wickelgütern, z. B. von Drosseln, dienen. Nach Unterbringung der Drosseln in den napf- oder topfartigen Vertiefungen 5 werden diese Vertiefungen oberflächengleich durch Schottbleche 10 verschlossen. Diese Schottbleche 10 werden mit dem Boden verschraubt. Die Schottbleche 10 sind vorteilhaft in Sandwich-Bauweise hergestellt und bieten insofern eine gewisse Dämmwirkung. Diese Schottbleche 10 besitzen zentrisch eine Öffnung 11 zur Durchführung von Kabeln zu den leistungselektronischen Bauteilen, die sich auf dem Boden 8 oberhalb der Vertiefungen in der Gehäusekammer 2 befinden. Das Gehäuse 1 selbst wird durch eine oder mehrere Deckel abgedeckt, die nicht dargestellt sind. Aus Figur 2 ergibt sich eine Ansicht von unten auf das Gehäuse. Die napfartigen Vertiefungen 5 weisen hierbei im Bereich ihrer Seitenwände 5a und im Bereich ihrer Bodenunterseite 5b Kühlrippen 6 auf. Darüber hinaus sind zwischen den einzelnen topf- oder napfartigen Vertiefungen weitere Kühlrippen 9 vorgesehen.

Erkennbar ist Folgendes:

Die napf- oder topfartigen Vertiefungen 5 zur Aufnahme von Wickelgut, insbesondere von Drosseln, sind Bestandteil des Bodens des Gehäuses bzw. der Gehäusekammer 2 und bilden insofern eine Gehäuseeinheit, die einer einzigen Schutzartklasse unterliegt, nämlich der Schutzartklasse IP 65. Dennoch erfolgt eine thermische Trennung zu den auf dem Boden 8 und gegebenenfalls auch auf den Schottblechen 10 angeordneten leistungselektronischen Bauteilen (nicht dargestellt), so dass der obere Teil der Gehäusekammer 2 nur eine geringe Erwärmung aufgrund der Wickelgüter in den Vertiefungen 5 erfährt. Insbesondere dann, wenn die Schottbleche selbst thermisch dämmend ausgebildet sind, wird die durch die Wickelgüter erzeugte Wärme im Wesentlichen unmittelbar durch die sie umgebende Vertiefung an die Umgebung abgegeben. Hierzu dienen insbesondere die Kühlrippen 6 unmittelbar an der Außenseite der Vertiefungen aber auch die zwischen den Vertiefungen angeordneten weiteren Kühlrippen 9.

## Patentansprüche

1. Wechselrichtergehäuse mit Wärme abgebenden, leistungselektronischen Bauteilen und Wärme abgebenden, elektrischen Wickelgütern und mit einer ersten und einer zweiten Gehäusekammer (2, 3)
**dadurch gekennzeichnet,**
**dass** die eine erste Gehäusekammer (2) die leistungselektronischen Bauteile des Wechselrichters aufnimmt,
**dass** im Boden (8) der ersten Gehäusekammer (2) mindestens eine napf- oder topfartige Vertiefung (5) zur Aufnahme der Wärme abgebenden, elektrischen Wickelgüter vorgesehen ist,
und **dass** sich die leistungselektronischen Bauteile oberhalb der zumindest einen Vertiefung (5) in der ersten Gehäusekammer (2) befinden.

2. Wechselrichtergehäuse nachAnspruch 1,
**dadurch gekennzeichnet,**
**dass** die Vertiefung (5) durch ein Schottblech (10) abdeckbar ist.

3. Wechselrichtergehäuse nach Anspruch 2,
**dadurch gekennzeichnet,**
**dass** das Schottblech (10) wärmedämmend ausgebildet ist.

4. Wechselrichtergehäuse nach einem der voranstehenden Ansprüche, **dadurch gekennzeichnet,**
**dass** das Gehäuse (1) auf der Außenseite der Vertiefung (5) Kühlrippen (6) aufweist.

5. Wechselrichtergehäuse nach einem der voranstehenden Ansprüche, **dadurch gekennzeichnet,**
**dass** seitlich zu der mindestens einen Vertiefung (5) außen am Gehäuseboden (2) Kühlrippen (9) angeordnet sind.

## Claims

1. Inverter housing comprising heat-emitting power electronics components and heat-emitting electrical winding elements and comprising a first and a second housing chamber (2, 3), **characterized in that** the first housing chamber (2) receives the power electronics components of the inverter, **in that** at least one cup- or pot-like recess (5) for receiving the heat-emitting, electrical winding elements is provided in the base (8) of the first housing chamber (2), and **in that** the power electronics components are located above the at least one recess (5) in the first housing chamber (2).

2. Inverter housing according to Claim 1, **characterized in that** the recess (5) is coverable by a partition plate (10).

3. Inverter housing according to Claim 2, **characterized in that** the partition plate (10) is configured to be thermally insulating.

4. Inverter housing according to one of the preceding claims, **characterized in that** the housing (1) comprises cooling ribs (6) on an outside of the recess (5).

5. Inverter housing according to one of the preceding claims, **characterized in that** cooling ribs (9) are arranged on the outside of a base of the housing chamber (2) to the side of the at least one recess (5).

## Revendications

1. Boîtier pour un redresseur présentant des composants électroniques de puissance émettant de la chaleur et des enroulements électriques émettant de la chaleur, le boîtier présentant une première et une deuxième chambre de boîtier (2, 3),
**caractérisé en ce que**
la première chambre (2) du boîtier reprend les composants électroniques de puissance du redresseur,
**en ce qu'**au moins un creux (5) en forme de cuvette ou de pot est prévu au fond (8) de la première chambre (2) du boîtier pour reprendre les enroulements électriques émettant de la chaleur et **en ce que** les composants électroniques de puissance sont situés au-dessus du ou des creux (5) ménagés dans la première chambre (2) du boîtier.

2. Boîtier pour redresseur selon la revendication 1, **caractérisé en ce que** le creux (5) peut être recouvert par une tôle d'étanchéité (10).

3. Boîtier pour redresseur selon la revendication 2, **caractérisé en ce que** la tôle d'étanchéité (10) est thermiquement isolante.

4. Boîtier pour redresseur selon l'une des revendications précédentes, **caractérisé en ce que** le boîtier (1) présente des nervures de refroidissement (6) sur le côté extérieur du creux (5).

5. Boîtier pour redresseur selon l'une des revendications précédentes, **caractérisé en ce que** des nervures de refroidissement (9) sont disposées à l'extérieur du fond (2) du boîtier, latéralement par rapport au creux ou aux creux (5).
